# EUROPÄISCHE PATENTSCHRIFT

(11) **EP 2 164 801 B1**
(45) Veröffentlichungstag und Bekanntmachung des Hinweises auf die Patenterteilung: **21.02.2018**
(21) Anmeldenummer: 08759997.3
(22) Anmeldetag: 26.05.2008
(51) Int. Cl.: B81B 7/00, H01L 23/48, H01L 21/768

(54) **ELEKTRISCHE KONTAKTIERUNG FÜR EIN MIKROMECHANISCHES BAUELEMENT**
MICROMECHANICAL COMPONENT AND METHOD FOR PRODUCING A MICROMECHANICAL COMPONENT
ÉLÉMENT MICROMÉCANIQUE ET PROCÉDÉ DE PRODUCTION DUDIT ÉLÉMENT MICROMÉCANIQUE

(30) Priorität: 06.06.2007 DE 102007026445
(43) Veröffentlichungstag der Anmeldung: 24.03.2010
(73) Patentinhaber: Robert Bosch GmbH, 70442 Stuttgart (DE)
(72) Erfinder: SCHMOLLNGRUBER, Peter, 71134 Aidlingen (DE); ARTMANN, Hans, 71034 Boeblingen-Dagersheim (DE); WAGNER, Thomas, 70567 Stuttgart (DE)
(86) Internationale Anmeldenummer: PCT/EP2008/056398
(87) Internationale Veröffentlichungsnummer: WO 2008/148654

(56) Entgegenhaltungen:
- DE-A1-102005 053 861

## Beschreibung

### Stand der Technik

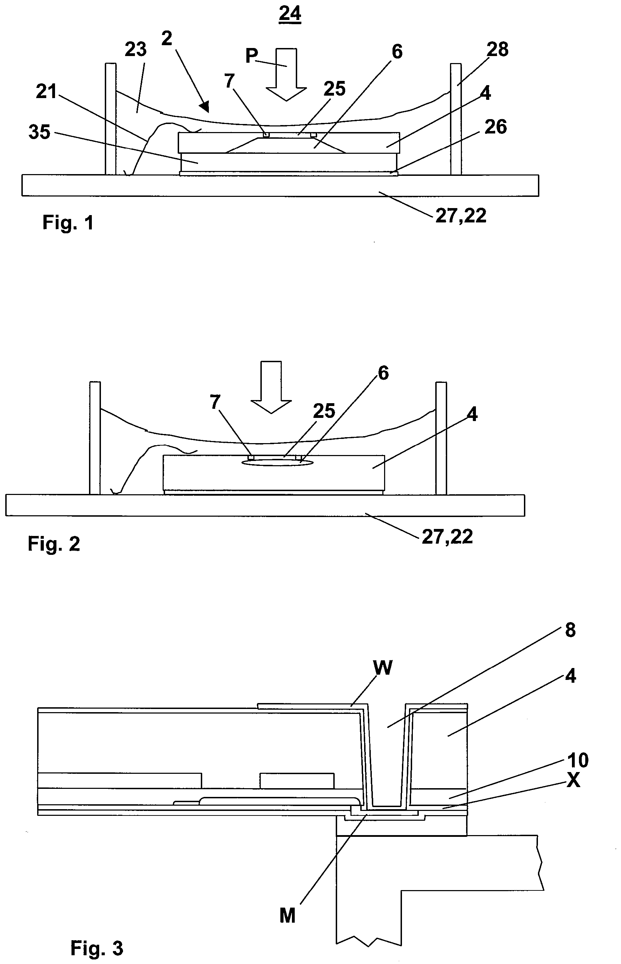

Die Erfindung geht aus von einem mikromechanischen Bauelement nach der Gattung des Hauptanspruchs. Aus der Druckschrift DE 103 23 559 A1 ist bereits eine mikromechanische Vorrichtung, insbesondere ein Drucksensor, bekannt, wobei der Drucksensor nach dem piezoresistiven Wandlerprinzip zur Umwandlung einer mechanischen Kraft in ein elektrisches Signal beruht. Ein üblicher Aufbau eines mikromechanischen Drucksensors mit piezoresistiven Wandlerelementen ist in Fig. 1 dargestellt. Ein Substrat mit einer anodisch geätzten Membran ist anodisch auf Glas gebondet. Es ist weiterhin nach der DE 100 32 579 A1 bekannt, die Membran und einen dahinter liegenden Hohlraum durch poröses Silizium herzustellen. Ein solcher Sensoraufbau ist in Fig. 2 dargestellt. Der Chip ist auf eine Keramik oder in ein Premoldgehäuse geklebt und zum Schutz gegen Umwelteinflüsse mit Gel passiviert, das durch einen Gelring auf dem Chip gehalten wird. Nachteilig an der Passivierung mit Gel ist, dass Gas, insbesondere unter hohem Druck, in das Gel eindiffundiert. Wird das gelöste Gas wieder gasförmig, beispielsweise bei einem Druckabfall, können die in dem Gel verlaufenden Bonddrähte, die den Kontakt zu dem Chip herstellen, zerstört werden. Aus der DE 103 59 217 A1 ist weiterhin eine elektrische Durchkontaktierung zur Rückseite des Substrats bekannt, wobei ein solcher Aufbau im Bereich der Kontaktlöcher verhältnismäßig dünn und somit wenig stabil ist.

Aus der Schrift DE 10 2005 053 861 A1 ist eine Sensoranordnung eines mikromechanischen Drucksensors bekannt, bei der eine Vorderseite eines Substrats mit einer Sensormembran dem Medium ausgesetzt ist und die Rückseite mit einer elektrischen Kontaktierung ausgestaltet ist. Hierzu wird durch das Substrat wenigstens ein Kontaktloch hindurch geführt.

### Offenbarung der Erfindung

Das erfindungsgemäße mikromechanische Bauelement mit den Merkmalen des Hauptanspruchs, sowie das erfindungsgemäße Verfahren zu seiner Herstellung gemäß dem nebengeordneten Anspruch haben dem gegenüber den Vorteil, dass das Substrat in dem Kontaktbereich eine höhere Stabilität bzw. Tragfähigkeit erhält. Durch eine solche Rückseitenkontaktierung werden auch Stresseinkopplungen auf der Vorderseite des mikromechanischen Bauelements, beispielsweise bei einer Flip-Chip-Montage verringert. Die Membran, im Sinne der Erfindung, besteht aus dem Substratmaterial, in der Regel also aus Silizium. Der Begriff "mechanisch stabile Membran" ist im Sinne der Erfindung bezeichnet eine Membran, welche einen Beitrag zur Tragfähigkeit des Substrats beisteuert. Die Membran kann somit eine im Verhältnis zu dem Substrat geringe Stärke aufweisen. Besonders vorteilhaft im Sinne der Stabilität ist eine Membran, welche eine Stärke aufweist, die beispielsweise die Hälfte der Stärke des Substrats beträgt. Mit dem Begriff Kontaktbereich ist im Sinne der Erfindung der gesamte Bereich zwischen der Vorderseite und der Rückseite des Substrats bezeichnet, in dem die Kontaktlöcher vorgesehen sind. Eine höhere Stabilität im Kontaktbereich erlaubt vorteilhafterweise größere Kontaktlöcher, d.h. Kontaktlöcher mit größerem Querschnitt. Dadurch besteht die vorteilhafte Möglichkeit, die Kontaktlöcher mit einer höheren Ätzrate zu Ätzen, was den Herstellungsprozess für das erfindungsgemäße mikromechanische Bauelement vereinfacht und beschleunigt. Die Funktionsstruktur weist beispielsweise geätzte und/oder dotierte Bereiche auf, welche die eigentliche Chipfunktion des erfindungsgemäßen mikromechanischen Bauelements ermöglichen, wie beispielsweise eine Sensorstruktur. Der Aufbau des erfindungsgemäßen mikromechanischen Bauelements ist einfach und kostengünstig herzustellen und ist besonders für mikromechanische Sensoren, insbesondere Drucksensoren geeignet. Besonders vorteilhaft ist das erfindungsgemäße mikromechanische Bauelement als Drucksensor in höheren Druckbereichen, beispielsweise bei 10 bar und mehr einsetzbar. Durch die erfindungsgemäße Gestaltung ist das mikromechanische Bauelement auch besonders geeignet für Absolut- oder Differenzdruckmessung in chemisch aggressiven Umgebungen, beispielsweise im Bereich von Partikelfiltern. Weitere Einsatzbereiche, in denen beispielsweise die Verwendung eines Bauelements mit einem passivierenden Gel nicht möglich oder zumindest schwierig ist, können vorteilhaft mit dem erfindungsgemäßen mikromechanischen Bauelement abgedeckt werden, beispielsweise als Sensor für Reifendrücke von Fahrzeugen oder als Drucksensor für Airbags, insbesondere Seitenairbags.

Durch die in den Unteransprüchen aufgeführten Maßnahmen sind vorteilhafte Weiterbildungen und Verbesserungen des in den nebengeordneten Ansprüchen angegebenen mikromechanischen Bauelements bzw. des Verfahrens zu seiner Herstellung möglich.

Die Kontaktierung erfolgt durch den Wafer, also durch das Substrat hindurch. Dazu weist das Substrat wenigstens ein Kontaktloch auf, beispielsweise vier Kontaktlöcher, die sich von der Rückseite des Substrats in dieses hinein erstrecken. Es ist bevorzugt, dass die elektrische Kontaktierung zwischen der Funktionsstruktur und der Rückseite aus einem elektrisch leitenden Material, insbesondere aus metallischen Leitern und/oder aus dotiertem Halbleitermaterial, besonders bevorzugt aus polykristallinem Silizium, gebildet ist. Weiterhin bevorzugt ist zumindest ein Teil der Rückseite und/oder das Kontaktloch mit dem elektrisch leitenden Material beschichtet, so dass die Rückseite des Substrats zumindest teilweise, insbesondere um die Kontaktlöcher herum, mit einer elektrisch leitenden Schicht versehen ist, die sich bis in die Kontaktlöcher hinein erstreckt, so dass eine elektrisch leitende Verbindung von der Rückseite bis in die Kontaktlöcher hinein gegeben ist. Die elektrische Kontaktierung zwischen der Funktionsstruktur und den Kontaktlöchern ist ebenfalls durch das elektrisch leitende Material realisiert, also beispielsweise durch metallische Leiter und/oder durch dotiertes Silizium. Auf der Rückseite ist vorzugsweise ein elektrischer Kontakt oder Kontaktbereich gebildet, der entweder direkt, beispielsweise über eine Flip-Chip-Kontaktierung oder aber über einen Bonddraht elektrisch leitend mit einer Leiterplatte verbindbar ist.

Weiterhin ist vorgesehen, dass die Vorderseite des Substrats eine Epitaxieschicht aufweist, wobei sich das Kontaktloch bis zu der Epitaxieschicht oder bis in die Epitaxieschicht erstreckt. Erfindungsgemäß ist zwischen dem Substrat und der Epitaxieschicht zumindest in dem Kontaktbereich eine Oxidschicht angeordnet, welche in vorteilhafter Weise als Stoppoxidschicht für einen Trenchätzprozess dienen kann, was die Toleranz bei der Herstellung der

### Kontaktlöcher erhöht.

Gemäß einer weiteren bevorzugten Ausführungsform ist vorgesehen, dass das Substrat in dem Kontaktbereich eine oder mehrere Durchkontaktierungen aufweist, wobei die Durchkontaktierungen das Kontaktloch mit der Vorderseite verbinden. Die Querschnittsfläche der Durchkontaktierungen im Sinne der Ausführungsform ist deutlich kleiner als die Querschnittsfläche des Kontaktlochs, so dass durch die Durchkontaktierungen vorteilhafterweise keine wesentlichen Einschränkungen der mechanischen Stabilität der Membran verursachen. Besonders bevorzugt sind die Durchkontaktierungen mit einem elektrisch leitenden Material beschichtet oder gefüllt.

Ein weiterer Gegenstand der Erfindung ist ein Verfahren zur Herstellung eines mikromechanischen Bauelements gemäß der Erfindung, wobei wenigstens ein Kontaktloch von der Rückseite her so in das Substrat eingebracht wird, dass die mechanisch stabile Membran zwischen dem Kontaktloch und der Vorderseite verbleibt, wobei der elektrische Kontakt zwischen der Funktionsstruktur und der Rückseite durch die Membran hindurch hergestellt wird. Durch das erfindungsgemäße Verfahren lassen sich vorteilhaft Substrate mit einer höheren Stabilität im Kontaktbereich herstellen, was beispielsweise größere Kontaktlöcher und damit ein Ätzen mit einer höheren Ätzrate zulässt. Die Herstellung nach dem erfindungsgemäßen Verfahren ist daher in vorteilhafter Weise besonders einfach und schnell.

Gemäß einer erfindungsgemäßen Ausführungsform ist vorgesehen, dass das Kontaktloch durch Trench-Ätzen hergestellt wird, wobei der Ätzprozess kontrolliert gestoppt wird, vorzugsweise an einer Epitaxieschicht oder in der Epitaxieschicht, sofern eine solche vorhanden ist. In einer besonders bevorzugten Ausführungsform wird vor dem Aufbringen der Epitaxieschicht zumindest in dem Kontaktbereich eine Oxidschicht auf das Substrat aufgebracht und der Ätzprozess an der Oxidschicht gestoppt. Die vorzugsweise durch thermische Oxidierung hergestellte Oxidschicht stoppt vorteilhaft den Ätzprozess und erlaubt so höhere Toleranzen.

Gemäß einer weiteren bevorzugten Ausführungsform ist vorgesehen, dass eine oder mehrere Durchkontaktierungen durch einen zweiten Ätzprozess hergestellt werden, so dass die Durchkontaktierungen das Kontaktloch mit der Vorderseite verbinden. Die Durchkontaktierungen können prinzipiell vor dem Ätzen der Kontaktlöcher hergestellt werden, wobei diese hier in diesem Fall als Sacklöcher bezeichnet werden, solange das Kontaktloch noch nicht geätzt ist. Bei vorherigem Ätzen der Kontaktlöcher, erfolgt die Herstellung der Durchkontaktierungen entweder von dem Kontaktloch aus, oder von der Vorderseite aus. Vor dem Ätzen der Durchkontaktierungen wird vorzugsweise eine Ätzmaske aufgetragen, beispielsweise mit einem Sprühlack. Werden die Durchkontaktierungen von dem Kontaktloch aus geätzt, so wird der Ätzprozess vorzugsweise an einer Oberflächenmetallisierung der Vorderseite gestoppt. Eine mögliche Rückseitenisolierung der Oberflächenmetallisierung wird zur Kontaktierung geöffnet, besonders bevorzugt mittels eines Trockenätzschritts. Das vorherige Auftragen des Sprühlacks kann wegen des hohen Aspektverhältnisses der schmalen Durchkontaktierung ohne Maske erfolgen.

Gemäß einer weiteren bevorzugten Ausführungsform ist vorgesehen, dass die Durchkontaktierungen durchgehend geätzt werden, eine Isolationsschicht abgeschieden wird und danach ein elektrisch leitendes Material aufgebracht wird, vorzugsweise in einem Schritt auf der Vorderseite und in der Durchkontaktierung, sowie vorzugsweise in dem Kontaktloch und/oder auf der Rückseite.

Dem Fachmann ist bekannt, dass vor dem Aufbringen eines elektrisch leitenden Materials zunächst eine Isolationsschicht aufgebracht wird, in der Regel durch Abscheidung. Das Aufbringen eines elektrisch leitenden Materials ist daher im Sinne der Erfindung, soweit erforderlich, stets im Zusammenhang mit dem vorhergehenden Abscheiden einer Isolationsschicht zu verstehen, auch wenn diese im Folgenden nicht notwendigerweise als Prozessschritt erwähnt ist.

Gemäß einer weiteren bevorzugten Ausführungsform ist vorgesehen, dass vor dem Ätzen des Kontaktlochs von der Vorderseite aus Sacklöcher hergestellt, isoliert und vorzugsweise mit einem elektrisch leitenden Material gefüllt werden, wobei die Sacklöcher durch das Ätzen des Kontaktlochs von der Rückseite her eröffnet werden und so die Durchkontaktierungen bilden.

Verfahren zur Abscheidung von bzw. Auffüllung mit elektrisch leitendem Material sind beispielsweise Sputtern, low-pressure chemical vapour deposition (LPCVD), Galvanik (mit und ohne Strom) oder Bedampfen.

Zur Isolierung des Kontaktbereichs ist vorzugsweise ein oxidierter Trenchisolationsgraben vorgesehen, welcher besonders bevorzugt gleichzeitig mit den Durchkontaktierungen oder Sacklöchern in einem Prozessschritt durch Trenchätzen hergestellt wird. Alternativ kann die Isolierung des Kontaktbereichs durch dotierte Bereiche erfolgen.

Ausführungsbeispiele der Erfindung sind in den Zeichnungen 4, 15 und 16 dargestellt und in der nachfolgenden Beschreibung näher erläutert.

### Kurze Beschreibung der Zeichnungen

Es zeigen
**Figuren 1 bis 3** Drucksensoren mit einem Sensoraufbau nach dem Stand der Technik,
**Figur 4** eine Schnittdarstellung einer erfindungsgemäßen Ausführungsform,
**Figur 5 bis 10** Schnittdarstellungen verschiedener Ausführungsformen eines mikromechanischen Bauelements, beziehungsweise Vorstufen im Herstellungsverfahren,
**Figuren 11 bis 14** **sowie 17** Schnittdarstellungen von beispielhaften Anwendungen der Ausführungsformen gemäß Figuren 5 bis 10,
**Figuren 15** **und** **16** Schnittdarstellungen von Anwendungen der Ausführungsform gemäß Figur 4.

### Detaillierte Beschreibung

In der **Figur 1** ist der Aufbau eines mikromechanischen Siliziumdrucksensors mit einer Funktionsstruktur 7, hier mit piezoresistiven Wandlerelementen, dargestellt. Ein Substrat 4 weist eine Vorderseite 2 auf, die einem Druckmedium 24 zugewandt ist. Der Druck des Mediums 24 wirkt in Richtung des Pfeils P auf den Drucksensor. An der Vorderseite 2 des Substrats 4 befindet sich eine Sensormembran 25 mit Funktionsstrukturen 7, hier mit piezoresistiven Wandlerelementen. Hinter der Sensormembran 25 ist eine Ausnehmung 6 in das Substrat 4 anisotrop eingeätzt. Durch anodisches Bonden des Substrats 4 auf ein Pyrexglas 35 bildet die Ausnehmung 6 einen Hohlraum 6 zwischen dem Substrat 4 und dem Pyrexglas 35. Der Verbund von Substrat 4 und Pyrexglas 35 ist mit einer Leiterplatte 22 bzw. einem Gehäuse 27, beispielsweise einem Premoldgehäuse, durch eine Klebeschicht 26 oder Lotschicht 26 verbunden. Die Vorderseite 2 des Substrats 4 ist mittels eines Bonddrahts 21 mit der Leiterplatte 22 elektrisch leitend verbunden. Ein Gelring 28 auf der Leiterplatte 22 bzw. dem Gehäuse 27 umschließt die Anordnung und ist mit einem passivierenden Gel 23 gefüllt. Der dargestellte Sensor ist ein Absolutdrucksensor. Die Dehnung der Sensormembran 25 durch den Druck des Mediums 24 wird durch die piezoresistiven Wandlerelemente gemessen, deren Signale mittels einer integrierten Schaltung ausgewertet werden können.

In der **Figur 2** ist ebenfalls ein Absolutdrucksensor nach dem Stand der Technik dargestellt. Die Sensormembran 25 mit dem dahinter liegenden Hohlraum 6 ist durch poröses Silizium mit einem oberflächenmikromechanischen Verfahren hergestellt, wie es in der DE 100 32 579 A1 beschrieben ist. Das Substrat 4 kann so vorteilhaft direkt auf eine Leiterplatte 22 bzw. ein Gehäuse 27 geklebt werden. Das anodische Bonden auf Glas kann so entfallen.

In **Figur 3** ist ein mikromechanisches Bauelement mit Waferdurchkontaktierung W des Substarts 4 durch ein Kontaktloch 8 nach dem Stand der Technik dargestellt. Ein Ätzstopp beim Trenchprozess erfolgt erst auf einem Oxid X, welches hier zwischen einer Epitaxieschicht 10 und einer Metallleiterbahn M angeordnet ist. Das mikromechanische Bauelement weist in diesem sehr dünnen Bereich eine verringerte mechanische Stabilität auf.

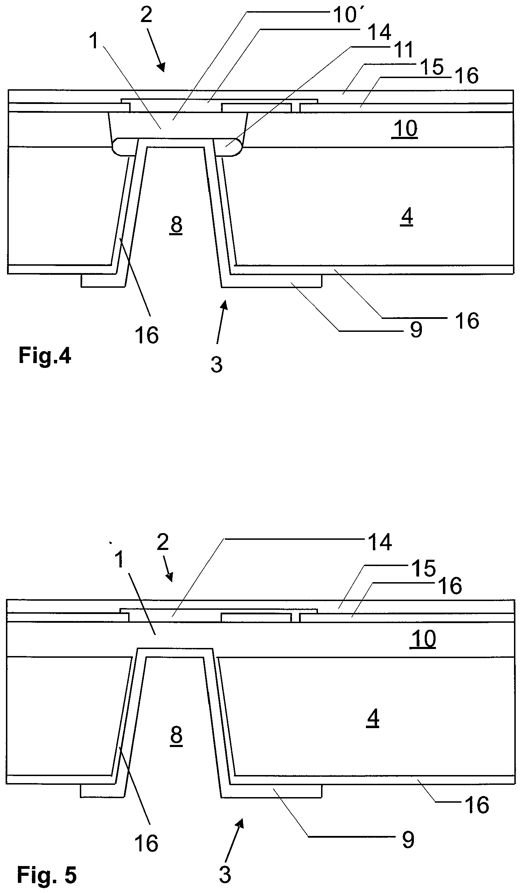

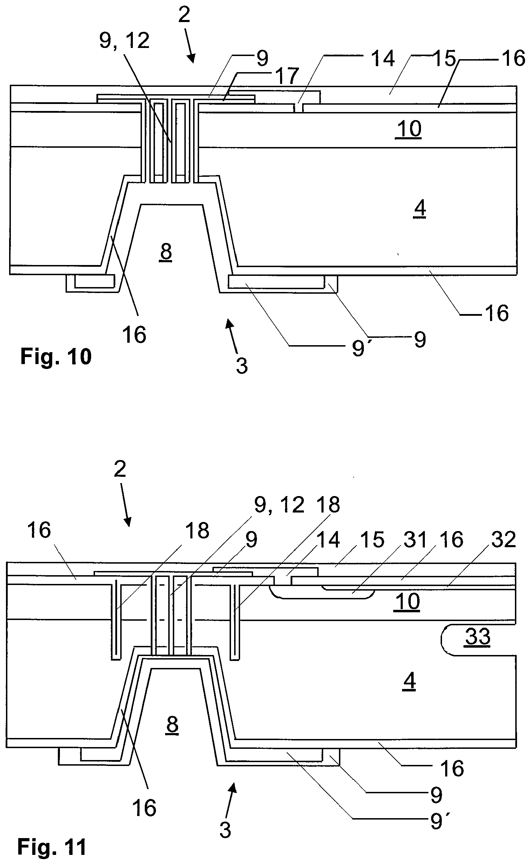

Die **Figur 4** zeigt einen schematischen Querschnitt einer ersten Ausführungsform eines erfindungsgemäßen mikromechanischen Bauelements mit einem Substrat 4, welches eine Vorderseite 2 und eine Rückseite 3 aufweist. Zur Herstellung eines Kontaktlochs 8 von der Rückseite 3 aus wird ein Trenchätzprozess angewendet, welcher auf einem thermischen Oxid 11 stoppt. So verbleibt eine Membran 1 zwischen dem Kontaktloch 8 und der Vorderseite 2, wobei die Membran 1 zur Stabilität des mikromechanischen Bauelements beiträgt. Das Oxid 11 wird vor dem Aufbringen einer Epitaxieschicht 10 in einem Kontaktbereich 5 abgelegt wird. Der Kontaktbereich 5 bezeichnet denjenigen Bereich des mikromechanischen Bauelements zwischen Vorderseite 2 und Rückseite 3, in welchem das Kontaktloch 8 angeordnet ist. Der Kontaktbereich 5 unterscheidet sich so von anderen, beispielsweise funktionalen Bereichen des mikromechanischen Bauelements, auf welche beispielhaft in den **Figuren 11 bis 17** eingegangen wird.

Der Prozess zur Herstellung des Kontaktlochs 8 umfasst beispielsweise die Schritte:
- thermische Oxidation und Strukturierung, der Oberfläche des Substrats 4
- Silizium-Epitaxie, wobei polykristallines Silizium (Epi-Poly) 10' oberhalb des Oxids 11 entsteht,
- Maskierung der Rückseite 3 für den Trenchätzprozess,
- Trenchätzen des Kontaktlochs 8 von der Rückseite mit Stopp in dem thermischen Oxid 11,
- Isolationsverfahren auf der Vorderseite, um die polykristallinen Siliziumbereiche gegeneinander zu isolieren, z.B. durch Dotierungsringe oder getrenchte und aufgefüllte, isolierende Gräben (nicht dargestellt),
- Abscheiden einer Isolationsschicht 16 auf der Rückseite, beispielsweise aus Oxid oder Nitrid,
- Lithographie der Rückseite 3 zur Öffnung der Isolationsschicht 16 und des thermischen Oxids 11 am Trenchboden des Kontaktlochs 8,
- Abscheidung und Strukturierung eines Anschlusses mit elektrisch leitfähigem Material 9 auf der Rückseite 3, beispielsweise Kontaktierung mit dotiertem, polykristallinem Sililizium oder Metall oder einer Kombination aus beidem.

An der Vorderseite 2 weist das mikromechanische Bauelement ebenfalls eine Isolationsschicht 16 und eine Passivierungsschicht 15, beispielsweise aus Siliziumnitrid, auf. Zur Kontaktierung dient hier eine Metallisierung 14. Die leitende Verbindung zwischen dem Rückseitenkontakt 9 und der Metallisierung 14 wird durch Dotierung des Epi-Poly 10' erreicht. Weitere Dotierungen auf der Wafervorderseite 2 zur Herstellung von Anschlüssen bzw. zur Herstellung der eigentlichen Chipfunktion sind hier nicht dargestellt. Auch nach dem Stand der Technik übliche Isolierungen, hier beispielsweise die der Bondpads, sind im Sinne der Übersichtlichkeit in den Figuren überwiegend nicht abgebildet.

In der **Figur 5** ist eine zweite Ausführungsform eines mikromechanischen Bauelements dargestellt. Der Trenchprozess zur Herstelllung des Kontaktlochs 8 stoppt hier in der Epitaxieschicht 10. Bei Prozessen, in denen keine Epitaxie vorgesehen ist, kann auch in dem Bulk-Silizium des Substrats 4 gestoppt werden. Gegenüber der Ausführungsform nach **Figur 4** ist der hier dargestellte Herstellungsprozess universeller anwendbar. Das thermische Oxidieren entfällt. Das gezielte Stoppen des Trenchätzprozesses ist andererseits anspruchsvoller, insbesondere da die Epitaxieschicht 10 mit einer Stärke von beispielsweise 10 Mikrometer in der Regel um ein Vielfaches dünner ist als das Substrat 4.

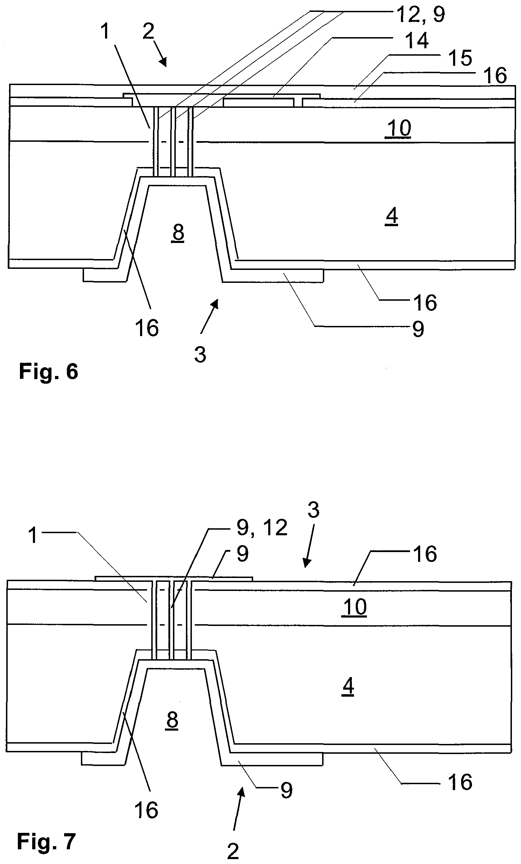

In der **Figur 6** ist eine dritte Ausführungsform des mikromechanischen Bauelements schematisch dargestellt. Hier werden in zwei aufeinander folgenden Trenchätzschritten das Kontaktloch 8 und eine oder mehrere Durchkontaktierungen 12 hergestellt. Die Membran 1 weist hier gegenüber den Ausführungsformen nach den Figuren 4 und 5 eine größere Stärke auf, was die Stabilität vorteilhaft erhöht. Die durchgehenden, im Querschnitt deutlich engeren Durchkontaktierungen 12 schränken die Stabilität dagegen nicht wesentlich ein. Ein weiterer Vorteil der Ausführungsform besteht darin, dass ein größerer Vorhalt bei dem Trenchen des Kontaktlochs 8 von der Rückseite 3 aus besteht. Prozesstoleranzen können dadurch besser ausgeglichen werden. Der Trenchätzprozess der Durchkontaktierungen 12 erfolgt ebenfalls von der Rückseite 3 aus und wird hier auf der Metallisierung 14 gestoppt. Der Prozess kann beispielsweise mit folgenden Schritten gestaltet werden:
- Maskierung der Rückseite 3 für den Trenchätzprozess des Kontaktlochs 8,
- Trenchätzen des Kontaktlochs 8 von der Rückseite 3, Stopp mit großem Vorhalt im Substrat 4,
- Sprühbelackung der Rückseite 3 mit Belichtung auf dem Trenchboden des Kontaklochs 8 als Maske für den Trenchätzprozess der Durchkontaktierungen 12,
- Trenchätzen der Durchkontaktierungen 12 von der Rückseite 3 aus, hier mit Stopp auf der Vorderseitenmetallisierung 14,
- Abscheiden einer Isolationsschicht 16,
- Sprühbelackung der Rückseite 3, wobei die Trenchböden der Durchkontaktierungen 12 wegen des hohen Aspektverhältnisses nicht oder nur unvollständig belackt werden,
- anisotroper Trockenätzschritt zur Öffnung der Isolation 16 der Metallisierung 14, sowie gegebenenfalls weiterer, nicht dargestellter Isolationsschichten,
- Abscheidung und Strukturierung des leitenden Materials 9 auf der Rückseite 3, in dem Kontaktloch 8 und in den Durchkontaktierungen 12.

Das Verfahren ist auch in Prozessen ohne Epitaxie anwendbar.

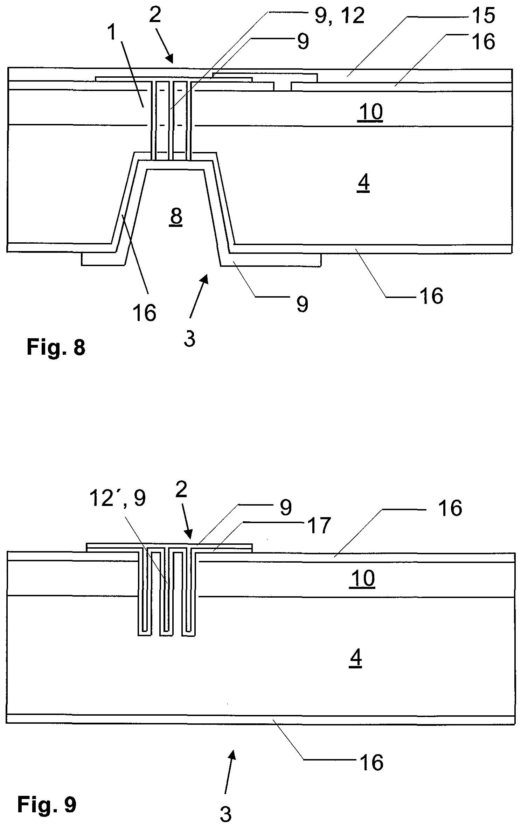

In den **Figuren 7** **und** **8** ist eine weitere Möglichkeit zur Herstellung einer Ausführungsform des mikromechanischen Bauelements, welches mit der Ausführungsform nach **Figur 6** vergleichbar ist, dargestellt. **Figur 7** zeigt eine Zwischenstufe, wobei das Kontaktloch 8 und die Durchkontaktierungen 12 zunächst durchgängig durch das Substrat 4 und die optionale Epitaxieschicht 10 hindurch geätzt werden. Für die Durchkontaktierungen 12 besteht hier auch die Möglichkeit, diese von der Vorderseite 2 aus zu Trenchen, was beispielsweise die Maskierung vereinfacht. Soweit dieses vor dem Trenchen des Kontaktlochs 8 erfolgt, wird hier auf Sacklöcher 12' (siehe Figur 9) Bezug genommen, welche durch das Eröffnen zu Durchkontaktierungen 12 werden. Die Ein Vorteil dieser Variante des Verfahrens besteht darin, dass mit einer Abscheidung von elektrisch leitfähigem Material 9, die Durchkontaktierungen 12 gefüllt werden und die Kontaktschichten auf der Vorderseite 2, im Kontaktloch 8 und/oder auf der Rückseite 3 hergestellt werden können. Die Metallisierung 14 und die Passivierungsschicht 15 werden nachträglich aufgebracht, wie in **Figur 8** dargestellt. Ein möglicher Prozess weist beispielsweise folgende Schrittfolge auf:
- Maskierung der Vorderseite 2 für den Trenchätzprozess der Sacklöcher 12' (siehe Figur 9),
- Trenchätzen der Sacklöcher 12',
- Maskierung der Rückseite 3 für den Trenchätzprozess des Kontaktlochs 8,
- Trenchätzen des Kontaktlochs 8 bis die Durchkontaktierungen 12 eröffnet werden,
- Abscheiden einer Isolationsschicht 16,
- Abscheiden von beispielsweise polykristallinem Silizium, vorzugsweise in einem LPCVD Verfahren (low-pressure chemical vapour deposition), gleichzeitig auf
- Vorderseite 2 und Rückseite 2, gegebenenfalls mit Dotierung in situ, oder mit nachfolgender Dotierung.

In den **Figuren 9** **und** **10** ist eine weitere Möglichkeit zur Herstellung der Ausführungsform des mikromechanischen Bauelements nach **Figur 8** dargestellt. **Figur 9** zeigt eine Zwischenstufe, wobei von der Vorderseite 2 zunächst Sacklöcher 12' geätzt werden und eine Isolationsschicht 16 abgeschieden wird. Im Anschluss werden die isolierten Sacklöcher 12' mit dem elektrisch leitfähigen Material 9, vorzugsweise polykristallinem Silizium, gefüllt. Zum Abscheiden der Isolationsschicht werden geeignete Verfahren angewandt, wie beispielsweise plasma-enhanced chemical vapour deposition (PECVD), sub-atmospheric chemical vapour deposition (SACVD) bei etwa 0,3 bar oder thermische Oxidation. Von der Rückseite 3 werden danach, wie in der **Figur 10** dargestellt, durch Ätzen des Kontaktlochs 8, die Durchkontaktierungen 12 geschaffen, indem die gefüllten Sacklöcher 12' aus **Figur 9** geöffnet werden. Ein Vorteil dieses Herstellungsverfahrens liegt darin, dass hier stets ein Ätzstopp im Substart 4 erfolgt, so dass das mikromechanische Bauelement zu keinem Zeitpunkt durchgehende Öffnungen aufweist, was in der Herstellung eine einfachere Handhabung erlaubt. Ein möglicher Prozess weist beispielsweise die folgende Schrittfolge auf:
- Maskierung der Vorderseite 2 für den Trenchätzprozess der Sacklöcher 12',
- Trenchätzen der Sacklöcher 12',
- Oxidation (Isolationsschicht 16),
- Abscheiden einer Nitridschicht 17, welche später als Maskierung bei thermischer Oxidation dienen kann, vorzugsweise im LPCVD Verfahren,
- Abscheiden von beispielsweise polykristallinem Silizium 9 auf der Vorderseite 2 und in den Sacklöchern 12,
- Maskierung der Rückseite 3 für das Kontaktloch 8,
- Oxidätzen des Kontaktlochs 8 von der Rückseite 3 bis das polykristalline Silizium 9 mit Nitridschicht 17 zum Teil freigelegt ist,
- Thermische Oxidation einer Isolation 16 im Kontaktloch 8, wobei sich auf dem polykristallinen Silizium 9 wegen der Nitridschicht 17 nur wenig Oxid bildet (dünnes ReOxid),
- Nitridätzen von der Rückseite 3, zum Beispiel in einem Trockenätzschritt mit höherer Nitridätzrate als Oxidätzrate, zur Entfernung des freigelegten Teils der Nitridschicht 17 von dem polykristallinem Silizium 9,
- Kontaktierung des freigelegten Teils des polykristallinen Siliziums 9, hier Beispielsweise durch einen Rückseitenkontakt mit einer Kombination aus polykristallinem Siliziums 9 und Metall 9'.

Vorteilhafterweise kann bei den zuvor beschriebenen Verfahren vor dem Trenchen des Kontaktlochs 8 von der Rückseite 2 aus das Substrat 4 rückgeschliffen werden. Dadurch lässt sich eine Verkürzung des Trenchschritts erreichen. Vorzugsweise wird ein ohnehin dünnes Substrat 4 eingesetzt.

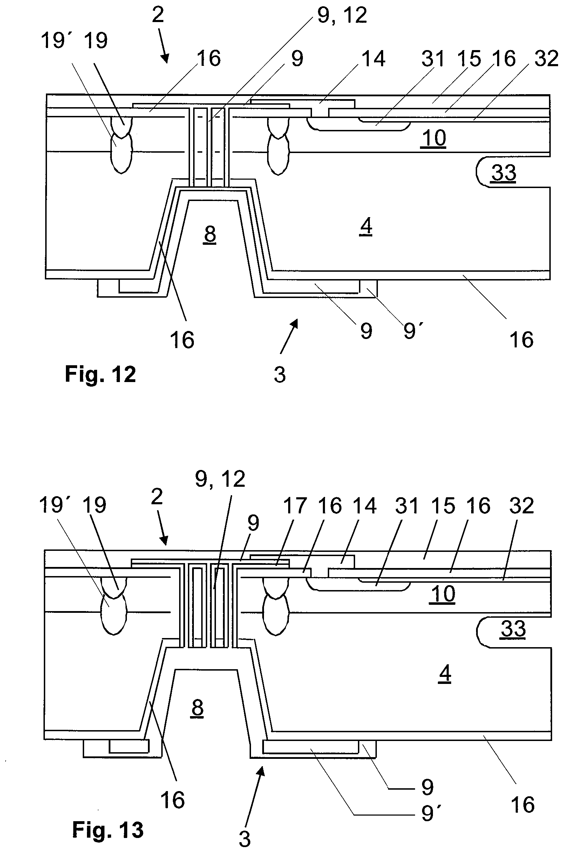

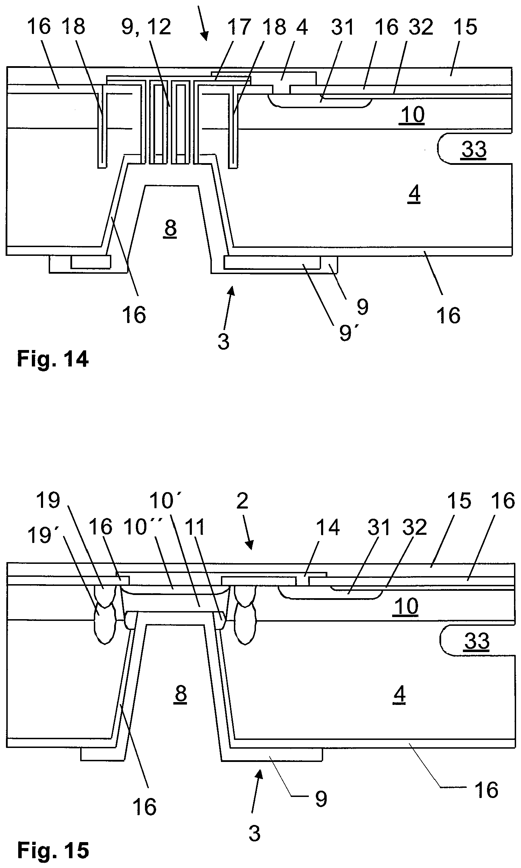

Die **Figuren 11** **und** **12** zeigen mögliche Anwendungen für die Ausführungsform gemäß der **Figur 8****.** Die **Figuren 13** **und** **14** zeigen die gleichen Anwendungen für die Ausführungsform gemäß der **Figur 10****.** Der Kontaktbereich 5 ist gegen den übrigen Bereich des Substrats 4 isoliert. Als Beispiel einer Funktionsstruktur 7 ist ein piezoresistiver oberflächenmikromechanischer (OMM) Drucksensor 7 dargestellt.

**Figur 11** zeigt oxidierte Trenchisolationsgräben 18 im Kontaktbereich 5, welche sich von der Isolationsschicht 16 der Vorderseite 2 durch die Epitaxieschicht 10 bis in das Substrat 4 erstrecken. Der piezoresistive OMM Drucksensor 7 weist eine p-dotierte Zuleitung 31 und einen p-dotierten Piezowiderstand 32 in der n-dotierten Epitaxieschicht 10, sowie eine Kaverne 33 in dem p-dotierten Substrat 4 auf. Die Funktionsstruktur 7, also der Drucksensor ist über die dotierte Zuleitung 31, die Metallisierung 14 und das polykristalline Silizium 9 elektrisch leitend mit der Rückseite 3 des mikromechanischen Bauelements verbunden.

**Figur 12** zeigt p-dotierte, obere Isolationsringe 19, welche sich von der Isolationsschicht 16 der Vorderseite 2 in die n-dotierten Epitaxieschicht 10 erstrecken und ebenfalls p-dotierte, untere Isolationsringe 19', welche sich von der Epitaxieschicht 10 bis in das p-dotierte Substrat 4 erstrecken. Der piezoresistive OMM Drucksensor entspricht **Figur 11****.**

**Figur 13** zeigt die Anwendung entsprechend **Figur 12****,** hier bei einer Ausführungsform des mikromechanischen Bauelements gemäß der **Figur 10****.** **Figur 14** zeigt die Anwendung entsprechend **Figur 11****,** ebenfalls bei einer Ausführungsform des mikromechanischen Bauelements gemäß der **Figur 10****.**

In den **Figuren 15 bis 17** ist als mögliche Funktionsstruktur 7 ebenfalls der piezoresistive OMM Drucksensor 7, wie in **Figuren 11 bis 14** dargestellt, hier jedoch für die Ausführungsformen des mikromechanischen Bauelements gemäß den **Figuren 4 und 5****.**

**Figur 15** bezieht sich auf die erste Ausführungsform des mikromechanischen Bauelements aus **Figur 4** und zeigt p-dotierte obere Isolationsringe 19, welche sich von der Isolationsschicht 16 der Vorderseite 2 in die n-dotierten Epitaxieschicht 10 erstrecken und ebenfalls p-dotierte, untere Isolationsringe 19', welche sich von der Epitaxieschicht 10 bis in das p-dotierte Substrat 4 erstrecken. Der n-dotierte, polykristalline Teil 10' (Epi-Poly) der Epitaxieschicht 10, oberhalb der Oxidschicht 11, weist hier einen Bereich mit erhöhter n-Dotierung 10" zur Kontaktierung der Metallisierung 14 auf.

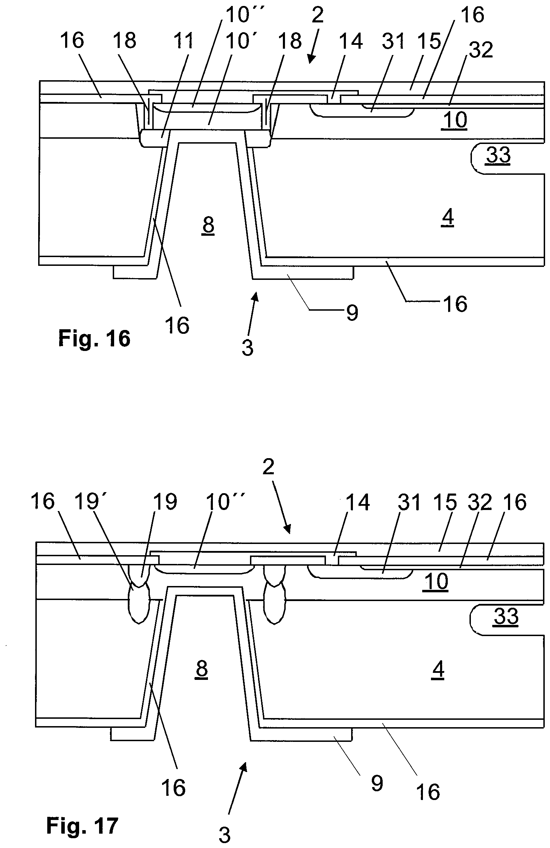

**Figur 16** bezieht sich ebenfalls auf die erste Ausführungsform des mikromechanischen Bauelements aus **Figur 4** und zeigt oxidierte Trenchisolationsgräben 18, welche sich von der Isolationsschicht 16 durch die Epitaxieschicht 10 bis zu der Oxidschicht 11 erstrecken. Das n-dotierte Epi-Poly 10' weist hier ebenfalls den Bereich mit erhöhter n-Dotierung 10" auf.

**Figur 17** bezieht sich auf die zweite Ausführungsform des mikromechanischen Bauelements aus **Figur 5** und zeigt p-dotierte obere Isolationsringe 19, welche sich von der Isolationsschicht 16 der Vorderseite 2 in die n-dotierten Epitaxieschicht 10 erstrecken und ebenfalls p-dotierte, untere Isolationsringe 19', welche sich von der Epitaxieschicht 10 bis in das p-dotierte Substrat 4 erstrecken. Unterhalb der Metallisierung 14 ist ein Bereich mit erhöhter n-Dotierung 10" zur Kontaktierung angeordnet.

## Patentansprüche

1. Mikromechanisches Bauelement , aufweisend ein Substrat (4) mit einer Vorderseite (2) und einer Rückseite (3), wobei
- die Vorderseite (2) eine Funktionsstruktur (7) aufweist, wobei die Funktionsstruktur (7) in einem Kontaktbereich (5) mit der Rückseite (3) elektrisch kontaktiert ist, und
- das Substrat (4) in dem Kontaktbereich (5) wenigstens ein Kontaktloch (8) aufweist, welches sich von der Rückseite (3) aus in das Substrat (4) hinein erstreckt, wobei zwischen dem Kontaktloch (8) und der Vorderseite (2) eine mechanisch stabile Membran (1) angeordnet ist, und
- die Vorderseite (2) des Substrats (4) eine Epitaxieschicht (10) aufweist, wobei sich das Kontaktloch (8) bis zu der Epitaxieschicht (10) oder bis in die Epitaxieschicht (10) erstreckt,
**dadurch gekennzeichnet dass**
zwischen dem Substrat (4) und der Epitaxieschicht (10) zumindest in dem Kontaktbereich (5) eine Oxidschicht (11) angeordnet ist.

2. Mikromechanisches Bauelement nach einem der vorhergehenden Ansprüche, **dadurch gekennzeichnet, dass** das Substrat (4) in dem Kontaktbereich (5) eine oder mehrere Durchkontaktierungen (12) aufweist, wobei die Durchkontaktierungen (12) das Kontaktloch (8) mit der Vorderseite (2) verbinden, und wobei die Durchkontaktierungen (12) vorzugsweise mit einem elektrisch leitenden Material (9) beschichtet oder gefüllt sind.

3. Verfahren zur Herstellung eines mikromechanischen Bauelements nach einem der vorhergehenden Ansprüche, **dadurch gekennzeichnet, dass** wenigstens ein Kontaktloch (8) von der Rückseite (3) her so in das Substrat (4) eingebracht wird, dass die mechanisch stabile Membran (1) zwischen dem Kontaktloch (8) und der Vorderseite (2) verbleibt, wobei der elektrische Kontakt zwischen der Funktionsstruktur (7) und der Rückseite (3) durch die Membran (1) hindurch hergestellt wird.

4. Verfahren nach Anspruch 3, **dadurch gekennzeichnet, dass** das Kontaktloch (8) durch Trench-Ätzen hergestellt wird, wobei der Ätzprozess kontrolliert gestoppt wird, an einer Epitaxieschicht (10) oder in der Epitaxieschicht (10), wobei vorzugsweise vor dem Aufbringen der Epitaxieschicht (10) zumindest in dem Kontaktbereich eine Oxidschicht (11) auf das Substrat (4) aufgebracht wird und der Ätzprozess an der Oxidschicht (11) gestoppt wird.

5. Verfahren nach einem der Ansprüche 3 oder 4, **dadurch gekennzeichnet, dass** eine oder mehrere Durchkontaktierungen (12) durch einen zweiten Ätzprozess hergestellt werden, so dass die Durchkontaktierungen (12) das Kontaktloch (8) mit der Vorderseite (2) verbinden.

6. Verfahren nach Anspruch 5, **dadurch gekennzeichnet, dass** die Durchkontaktierungen (12) von dem Kontaktloch (8) aus geätzt werden, wobei der Ätzprozess vorzugsweise an einer Oberflächenmetallisierung (13) der Vorderseite (2) gestoppt wird.

7. Verfahren nach Anspruch 5, **dadurch gekennzeichnet, dass** die Durchkontaktierungen (12) durchgehend geätzt werden, eine Isolationsschicht abgeschieden wird und danach ein elektrisch leitendes Material (9) aufgebracht wird, vorzugsweise in einem Schritt auf der Vorderseite (2) und in der Durchkontaktierung (12), sowie vorzugsweise in dem Kontaktloch (8) und/oder auf der Rückseite (3).

8. Verfahren nach einem der Ansprüche 3 bis 5, **dadurch gekennzeichnet, dass** vor dem Ätzen des Kontaktlochs (8), von der Vorderseite (2) aus, Sacklöcher (12') hergestellt, isoliert und vorzugsweise mit einem elektrisch leitenden Material (9) gefüllt werden, wobei die Sacklöcher (12') durch das Ätzen des Kontaktlochs (8) von der Rückseite (3) her eröffnet werden und so die Durchkontaktierungen (12) bilden.

9. Verfahren nach einem der Ansprüche 5 bis 8, **dadurch gekennzeichnet, dass** mindestens ein oxidierter Trenchisolationsgraben (18) gleichzeitig mit den Durchkontaktierungen (12) oder Sacklöchern (12') in einem Prozessschritt durch Trenchätzen hergestellt wird.

## Claims

1. Micromechanical component, having a substrate (4) with a front side (2) and a rear side (3), wherein
- the front side (2) has a functional structure (7), the functional structure (7) being electrically contacted with the rear side (3) in a contact region (5), and
- the substrate (4) has at least one contact hole (8) in the contact region (5), said contact hole extending from the rear side (3) into the substrate (4), a mechanically stable diaphragm (1) being arranged between the contact hole (8) and the front side (2), and
- the front side (2) of the substrate (4) has an epitaxial layer (10), the contact hole (8) extending up to the epitaxial layer (10) or as far as into the epitaxial layer (10),
**characterized in that**
an oxide layer (11) is arranged between the substrate (4) and the epitaxial layer (10) at least in the contact region (5).

2. Micromechanical component according to one of the preceding claims, **characterized in that** the substrate (4) has one or more plated-through holes (12) in the contact region (5), the plated-through holes (12) connecting the contact hole (8) to the front side (2), and the plated-through holes (12) preferably being coated or filled with an electrically conductive material (9).

3. Method for producing a micromechanical component according to either of the preceding claims, **characterized in that** at least one contact hole (8) is introduced from the rear side (3) into the substrate (4) in such a manner that the mechanically stable diaphragm (1) remains between the contact hole (8) and the front side (2), the electrical contact between the functional structure (7) and the rear side (3) being produced through the diaphragm (1).

4. Method according to Claim 3, **characterized in that** the contact hole (8) is produced by trench etching, the etching process being stopped in a controlled manner at an epitaxial layer (10) or in the epitaxial layer (10), an oxide layer (11) being applied to the substrate (4) at least in the contact region, preferably before the epitaxial layer (10) is applied, and the etching process being stopped at the oxide layer (11).

5. Method according to either of Claims 3 and 4, **characterized in that** one or more plated-through holes (12) are produced by a second etching process, such that the plated-through holes (12) connect the contact hole (8) to the front side (2).

6. Method according to Claim 5, **characterized in that** the plated-through holes (12) are etched starting from the contact hole (8), the etching process preferably being stopped at a surface metallization (13) of the front side (2).

7. Method according to Claim 5, **characterized in that** the plated-through holes (12) are etched continuously, an insulation layer is deposited, and thereafter an electrically conductive material (9) is applied, preferably in one step to the front side (2) and in the plated-through hole (12), and also preferably in the contact hole (8) and/or on the rear side (3).

8. Method according to one of Claims 3 to 5, **characterized in that**, before the contact hole (8) is etched, blind holes (12') are produced starting from the front side (2), are insulated, and are preferably filled with an electrically conductive material (9), the blind holes (12') being opened by the etching of the contact hole (8) from the rear side (3) and thereby forming the plated-through holes (12).

9. Method according to one of Claims 5 to 8, **characterized in that** at least one oxidized insulation trench (18) is produced simultaneously with the plated-through holes (12) or blind holes (12') in one process step by trench etching.

## Revendications

1. Composant micromécanique, possédant un substrat (4) ayant un côté avant (2) et un côté arrière (3),
- le côté avant (2) possédant une structure fonctionnelle (7), la structure fonctionnelle (7) étant mise en contact électrique avec le côté arrière (3) dans une zone de contact (5), et
- le substrat (4) possédant dans la zone de contact (5) au moins un trou de contact (8) qui s'étend à l'intérieur du substrat (4) depuis le côté arrière (3), une membrane (1) mécaniquement stable étant disposée entre le trou de contact (8) et le côté avant (2), et
- le côté avant (2) du substrat (4) possédant une couche épitaxiale (10), le trou de contact (8) s'étendant jusqu'à la couche épitaxiale (10) ou jusque dans la couche épitaxiale (10),
**caractérisé en ce que**
une couche d'oxyde (11) est disposée au moins dans la zone de contact (5) entre le substrat (4) et la couche épitaxiale (10).

2. Composant micromécanique selon l'une des revendications précédentes, **caractérisé en ce que** le substrat (4) possède dans la zone de contact (5) un ou plusieurs contacts traversants (12), les contacts traversants (12) reliant le trou de contact (8) au côté avant (2) et les contacts traversants (12) étant de préférence revêtus ou remplis d'un matériau électriquement conducteur (9).

3. Procédé de fabrication d'un composant micromécanique selon l'une des revendications précédentes, **caractérisé en ce qu'**au moins un trou de contact (8) est pratiqué dans le substrat (4) depuis le côté arrière (3) de telle sorte que la membrane (1) mécaniquement stable demeure entre le trou de contact (8) et le côté avant (2), le contact électrique entre la structure fonctionnelle (7) et le côté arrière (3) étant établi à travers la membrane (1).

4. Procédé selon la revendication 3, caractérisé en cè que le trou de contact (8) est produit par gravure de tranchée, le processus de gravure étant arrêté de manière contrôlée au niveau d'une couche épitaxiale (10) ou dans la couche épitaxiale (10), une couche d'oxyde (11) étant appliquée sur le substrat (4) au moins dans la zone de contact avant l'application de la couche épitaxiale (10) et le processus de gravure étant arrêté au niveau de la couche d'oxyde (11).

5. Procédé selon l'une des revendications 3 ou 4, **caractérisé en ce qu'**un ou plusieurs contacts traversants (12) sont produits par un deuxième processus de gravure, de sorte que les contacts traversants (12) relient le trou de contact (8) au côté avant (2).

6. Procédé selon la revendication 5, **caractérisé en ce que** les contacts traversants (12) sont gravés depuis le trou de contact (8), le processus de gravure étant de préférence arrêté au niveau d'une métallisation de surface (13) du côté avant (2).

7. Procédé selon la revendication 5, **caractérisé en ce que** les contacts traversants (12) sont gravés en continu, une couche isolante est précipitée et un matériau électriquement conducteur (9) est ensuite appliqué, de préférence en une étape sur le côté avant (2) et dans le contact traversant (12), ainsi que de préférence dans le trou de contact (8) et/ou sur le côté arrière (3).

8. Procédé selon l'une des revendications 3 à 5, **caractérisé en ce qu'**avant la gravure du trou de contact (8), des trous borgnes (12') sont produits, isolés et de préférence remplis d'un matériau électriquement conducteur (9) depuis le côté avant (2), les trous borgnes (12') étant ouverts depuis le côté arrière (3) par la gravure du trou de contact (8) et formant ainsi les contacts traversants (12).

9. Procédé selon l'une des revendications 5 à 8, **caractérisé en ce qu'**au moins une rainure d'isolation de tranchée oxydée (18) est produite simultanément avec les contacts traversants (12) ou les trous borgnes (12') dans une étape de processus par gravure de tranchée.
